**Europäisches Patentamt**

**European Patent Office**

**Office européen des brevets**

(19)

(11) Numéro de publication: **0 124 421**
A1

# DEMANDE DE BREVET EUROPEEN

(12)

(21) Numéro de dépôt: **84400795.5**

(22) Date de dépôt: **19.04.84**

(51) Int. Cl.³: **H 05 K 7/20**, H 01 L 23/36

---

(30) Priorité: **29.04.83 FR 8307177**

(43) Date de publication de la demande: **07.11.84**
**Bulletin 84/45**

(84) Etats contractants désignés: **DE GB**

(71) Demandeur: **THOMSON-CSF, 173, Boulevard Haussmann, F-75379 Paris Cedex 08 (FR)**

(72) Inventeur: **Beau, Christian, THOMSON-CSF SCPI 173, bld Haussmann, F-75379 Paris Cedex 08 (FR)**
Inventeur: **Ormieres, André, THOMSON-CSF SCPI 173, bld Haussmann, F-75379 Paris Cedex 08 (FR)**
Inventeur: **Moutet, Philippe, THOMSON-CSF SCPI 173, bld Haussmann, F-75379 Paris Cedex 08 (FR)**
Inventeur: **Gueuret, Raymond, THOMSON-CSF SCPI 173, bld Haussmann, F-75379 Paris Cedex 08 (FR)**
Inventeur: **Lagrue, Serge, THOMSON-CSF SCPI 173, bld Haussmann, F-75379 Paris Cedex 08 (FR)**

(74) Mandataire: **Lincot, Georges et al, THOMSON-CSF SCPI 173, Bld Haussmann, F-75379 Paris Cedex 08 (FR)**

---

(54) **Procédé de fabrication d'un dissipateur thermique à picots et dissipateur obtenu par ce procédé.**

(57) Le procédé selon l'invention consiste à usiner séparatément la semelle (4) et les picots (1) du radiateur et à emmancher une extrémité de chaque picot (1) à force dans un trou correspondant percé dans la semelle (4).

Application: refroidissement des composants électroniques à forte dissipation thermique.

1

Procédé de fabrication d'un dissipateur thermique à picots
et dissipateur obtenu par ce procédé.

La présente invention concerne un procédé de fabrication d'un dissipateur thermique à picots et un dissipateur obtenu par ce procédé. Le dissipateur obtenu par le procédé selon l'invention peut s'appliquer, de façon générale, au refroidissement des composants électroniques à forte dissipation thermique, et en particulier au refroidissement de têtes relais de télévision, des amplificateurs à effet de champ travaillant à très haute fréquence, ainsi qu'au refroidissement des cellules à effet Pelletier.

Les dissipateurs à picots sont généralement constitués par un support de base plan, formant semelle, sur lequel de nombreux éléments cylindriques appelés picots sont disposés perpendiculairement à au moins une face de ce support.

Les procédés de fabrication connus pour réaliser les dissipateurs à picots consistent, soit à mouler directement le dissipateur par des procédés connus de fonderie, au sable, à la cire perdu ou encore de microfusion, soit à souder au bain de sel les picots directement sur la semelle.

Les dissipateurs obtenus par ces procédés ont pour principaux inconvénients d'être relativement coûteux et d'avoir des performances limitées.

Les procédés de moulage ont pour inconvénients qu'ils ne permettent pas d'obtenir des picots de grandes longueurs avec une densité de répartition sur la semelle importante. Les alliages à bonne conductibilité thermique utilisés présentent généralement une mauvaise coulabilité ce qui conduit à réduire la longueur des picots et leur densité de répartition, limitant ainsi, par voie de conséquence, la surface de contact avec le fluide de refroidissement. De plus le métal en fusion tend à se refroidir avant d'atteindre le fond des cavités du moule si celles-ci sont profondes et de faible section ; par ailleurs, lors du démoulage certains picots se brisent et restent à l'intérieur du moule. La nécessité de pouvoir démouler limite les formes des dissipateurs à picots obtenus par fonderie, dont l'embase est, de ce fait, généralement plane et les picots perpendiculaires à cette embase. A ces inconvénients s'ajoutent le coût élevé d'un moule et les difficultés rencontrées pour obtenir des modifications des caractéristiques du dissipateur.

La technique de soudage et d'assemblage au bain de sel a pour principaux inconvénients, de requérir un temps d'exécution long et de n'être pas compatible avec les exigences d'une production de dissipateurs en série. En outre, cette technique nécessite un outillage coûteux, l'utilisation d'un alliage spécial pour former les dissipateurs, et un procédé d'exécution délicat.

Le but de l'invention est de pallier les inconvénients précités.

A cet effet, l'invention a pour objet un procédé de fabrication d'un dissipateur thermique à picots, de type comprenant, une semelle recouverte sur au moins une de ses faces par des picots, caractérisé en ce qu'il consiste à usiner séparement la semelle et les picots et à emmancher une extrémité de chaque picot à force dans un trou correspondant percé dans la semelle.

L'invention a également pour objet un dissipateur thermique obtenu par le procédé de fabrication précité.

Le dissipateur obtenu par le procédé de fabrication selon l'invention a pour principaux avantages d'assurer un bon couplage thermique entre l'organe à refroidir et le milieu ambiant tout en étant simple et peu coûteux. Le procédé ne nécessite pas d'outillage particulier. Les dissipateurs obtenus peuvent avoir des picots de longueur et d'inclinaison quelconques, espacés entre eux selon des écartements également quelconques, ce qui permet de les adapter facilement à toutes les configurations thermiques qui peuvent se présenter.

D'autres caractéristiques et avantages de l'invention apparaîtront au cours de la description faite au regard des dessins annexés qui va suivre présentée, uniquement à titre d'exemple, et qui représentent un mode de réalisation d'un dissipateur obtenu par le procédé selon l'invention.

Le procédé de fabrication selon l'invention consiste, à usiner séparément la semelle et les picots du dissipateur dans un matériau bon conducteur de la chaleur tel que le cuivre ou un alliage léger par exemple d'aluminum et à emmancher une extrémité de chaque picot à force dans un trou correspondant percé dans la semelle. Le perçage dans la semelle peut être facilement réalisé par une machine à commande numérique ou par une machine à broches multiples ou par tous autres moyens de perçage équivalents.

Les picots sont obtenus de préférence par décolletage et ont un diamètre d'extrémité qui correspond au diamètre du trou correspondant percé dans la semelle. Pour améliorer la conductibilité thermique entre chaque picot et la semelle, une colle thermiquement conductrice peut être appliquée à une extrémité des picots avant de les engager dans les trous correspondants de la semelle.

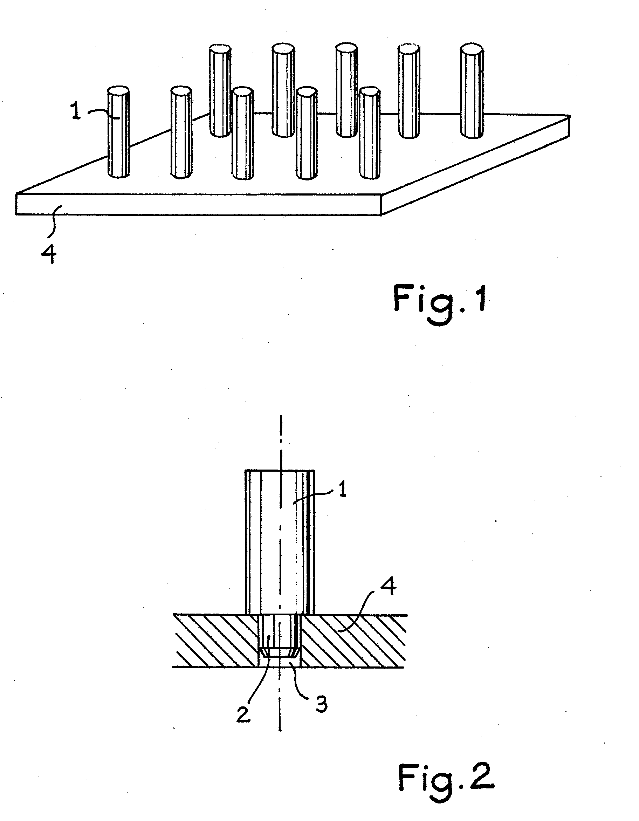

Un exemple de dissipateur thermique obtenu par le procédé selon l'invention est représenté aux figures 1 et 2. Il est constitué par des picots 1, ayant chacun une extrémité formée par un épaulement 2, emmanchée à force dans un trou 3 correspondant, percé dans une semelle 4.

La détermination des caractéristiques dimensionnelles des dissipateurs ainsi réalisés n'offre pas de difficulté, elle sera obtenue dans tous les cas à partir des caractéristiques de puissance dissipée P, des écarts de température $\Delta T$ souhaité entre la température ambiante et les éléments électroniques placés directement en contact avec des dissipateurs, ainsi que du coefficient de convection $H_C$. Lorsque ces trois paramètres sont connus, la surface de dissipation est déterminée par la formule $S = \dfrac{P}{H_C . \Delta T}$ . Connaissant la surface S, il est alors aisé de déterminer le nombre de picots à partir des dimensions données à chaque picot pour constituer le dissipateur. Suivant les applications, l'optimisation du pas des picots, pourra être rendue nécessaire suivant que le dissipateur est utilisé en convection naturelle ou en convection forcée.

Bien que le principe de la présente invention ait été décrit ci-dessus en relation avec un seul exemple particulier de réalisation, il faut comprendre que la description n'a été faite qu'à titre d'exemple et ne limite pas la portée de l'invention.

D'autres variantes de réalisation sont en effet possibles, notamment, en modifiant les formes données, soit à la semelle, soit aux picots. C'est ainsi qu'il sera tout aussi possible de donner à la semelle une forme carrée, rectangulaire, circulaire ou toute forme volumique quelconque

4

notamment cubique ou cylindrique, susceptible de faire rayonner le dissipateur dans toutes les directions ou permettant sa meilleure adaptation, lorsqu'il est utilisé en convection forcée pour permettre un excellent brassage de l'air vis-à-vis des picots. Egalement, la forme cylindrique des picots représentée à la figure 1 n'est pas unique et ont pourra tout aussi bien concevoir des modes de réalisation de dissipateur avec des picots présentant d'autres formes, par exemple tronconiques, sans pour autant sortir du cadre même de l'invention.

## REVENDICATIONS

1. Procédé de fabrication d'un dissipateur thermique à picots du type comprenant une semelle (4) recouverte sur au moins une de ses faces par des picots (1), caractérisé en ce qu'il consiste à usiner séparément la semelle (4) et les picots (1) et à emmancher une extrémité de chaque picot (1) à force dans un trou (3) correspondant percé dans la semelle (4).

2. Procédé selon la revendication 1, caractérisé en ce que chaque trou (3) percé dans la semelle (4) est réalisé à l'aide d'une machine de perçage à commande numérique.

3. Procédé selon la revendication 1, caractérisé en ce que le perçage des trous (3) dans la semelle (4) est réalisé à l'aide d'une machine de perçage à broches multiples.

4. Procédé selon l'une quelconque des revendications 1 à 3, caractérisé en ce que chaque picot (1) est obtenu par décolletage.

5. Procédé selon l'une quelconque des revendications 1 à 4, caractérisé en ce que l'extrémité (2) d'un picot qui est engagée dans un trou (3) percé correspondant de la semelle (4) est recouverte d'une colle thermiquement conductrice.

6. Dissipateur thermique, caractérisé en ce qu'il comprend des picots (1) ayant chacun une extrémité(2) emmanchée à force dans un trou (3) correspondant percé dans une semelle (4).

7. Dissipateur thermique selon la revendication 6, caractérisé en ce que les picots (1) ont une forme cylindrique.

8. Dissipateur thermique selon la revendication 6, caractérisé en ce que les picots ont une forme tronconique.

9. Dissipateur thermique selon l'une quelconque des revendications 6 à 8, caractérisé en ce que la semelle (4) et les picots (1) sont constitués par un métal d'alliage léger bon conducteur de la chaleur.

10. Dissipateur thermique selon l'une quelconque des revendications 6 à 8, caractérisé en ce que la semelle (4) et les picots (1) sont en cuivre.

Fig.1

Fig.2

0124421

Office européen
des brevets

**RAPPORT DE RECHERCHE EUROPEENNE**

Numéro de la demande

EP  84 40 0795

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | EP-A-0 031 419  (IBM CORP.) * Page 4, ligne 5 - page 5, ligne 12; revendications 1-8; figure * | 1,5 | H 05 K    7/20 H 01 L   23/36 |
| A | US-A-1 977 731  (A.F. MASURY) * En entier * | 1,6-9 | |
| A | IBM TECHNICAL DISCLOSURE BULLETIN, vol. 24, no. 3, août 1981, pages 1668-1669, New York, USA; R.J. REDMOND: "High thermal-transfer module" * En entier * | 1,6,7 | |
| A | IBM TECHNICAL DISCLOSURE BULLETIN, vol. 20, no. 7, décembre 1977, pages 2637-2638, New York, USA; R.A. FOSTER et al.: "Thermally enhanced package for semiconductor devices" * En entier * | 1,6,7 | DOMAINES TECHNIQUES RECHERCHES (Int. Cl. ³) H 05 K H 01 L F 28 F |

Le présent rapport de recherche a été établi pour toutes les revendications

| Lieu de la recherche | Date d'achèvement de la recherche | Examinateur |
|---|---|---|
| LA HAYE | 06-08-1984 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                    

& : membre de la même famille, document correspondant

OEB Form 1503. 03.82